# DEMANDE DE BREVET EUROPEEN

(11) **EP 1 333 469 A1**
(43) Date de publication de la demande: **06.08.2003**
(21) Numéro de dépôt: 03290049.0
(22) Date de dépôt: 09.01.2003
(51) Int. Cl.: H01L 21/00

(54) **Enceinte de stockage, valve d'évacuation de gaz et procédé d'alimentation en gaz**

(30) Priorité: 24.01.2002 FR 0200866
(71) Demandeur: L'Air Liquide Société Anonyme à Directoire et Conseil de Surveillance pour l'Etude et l'Exploitation des Procédé Georges Claud, 75321 Paris Cedex 07 (FR)
(72) Inventeur: Chevalier, Gilbert, 78960 Voisins le Bretonneux (FR); LeTurmy, Marc, 78550 Gressey (FR)
(74) Mandataire: Mellul-Bendelac, Sylvie Lisette

(57) **Abrégé**

Cette enceinte (2) comprend un châssis (4), des moyens de fourniture d'un gaz, notamment de l'azote, au moins une porte (10) prenant appui, dans une position de fermeture, contre une surface d'appui (20) appartenant au châssis, ainsi qu'au moins un organe de verrouillage (22) mobile entre des positions respectives de verrouillage et de déverrouillage de la porte (10) par rapport au châssis.

Cette porte est apte à passer, dans la position de verrouillage dudit organe, de sa position de fermeture vers une position d'évacuation du gaz hors de l'enceinte, dans laquelle la face intérieure (18) de la porte est distante de la surface d'appui (20), et il est prévu des moyens de rappel (34), aptes à ramener la porte de sa position d'évacuation vers sa position de fermeture.

## Description

La présente invention concerne une enceinte de stockage, une valve d'évacuation de gaz pour une telle enceinte, ainsi qu'un procédé d'alimentation en gaz de cette enceinte.

L'invention vise, en particulier, le stockage de plaquettes de silicium, destinées à porter des circuits micro-électroniques. Elle s'adresse, de manière plus spécifique, à l'électronique dite secondaire, qui consiste principalement à fabriquer des cartes de circuits imprimés, ainsi qu'à braser des composants électroniques sur ces cartes.

Or, ces différents composants peuvent être sensibles à la présence d'humidité, voire à la présence d'oxygène, ainsi qu'à certains polluants dans l'air. En effet, l'humidité de l'air a tendance à s'adsorber dans les composants.

Ainsi, lors de l'opération de brasage, les composants sont portés très rapidement de la température ambiante, jusqu'à plus de 200°C. La phase aqueuse piégée dans ces composants se vaporise alors brutalement, ce qui provoque un phénomène dit de « délamination », susceptible d'induire une destruction de ces composants.

Afin de remédier à ce problème, il est connu de stocker les composants dans des emballages spéciaux, encore appelés « DRY PACK ». Ces emballages ne sont cependant pas totalement satisfaisants, étant donné que leur durée d'utilisation est relativement faible.

Il a donc été proposé de faire appel à des enceintes de stockage, qui sont en permanence alimentées au moyen d'un gaz sec, en particulier de l'azote. De la sorte, il est possible de maintenir les composants à l'intérieur de cette enceinte, tout en garantissant leur intégrité mécanique et électrique.

De façon classique, une telle enceinte de stockage comprend un châssis, ainsi qu'au moins une porte permettant d'accéder au volume intérieur. I1 est par ailleurs prévu des moyens de fourniture d'un gaz sec, en particulier de l'azote, assurant un balayage continuel de l'enceinte.

L'invention se propose de réaliser une enceinte de stockage du type précité qui, tout en garantissant de manière fiable l'intégrité des composants qui y sont reçus, offre aux opérateurs des conditions de sécurité améliorées, par rapport à celles prévalant dans l'art antérieur.

A cet effet, elle a pour objet une enceinte de stockage, notamment pour des plaquettes de silicium destinées à la micro-électronique, comprenant un châssis, des moyens de fourniture d'un gaz, notamment de l'azote, ainsi qu'au moins une porte permettant d'accéder à un volume intérieur de l'enceinte, la face intérieure de la porte prenant appui, dans une position de fermeture, contre une surface d'appui appartenant au châssis, caractérisée en ce que l'enceinte comporte également au moins un organe de verrouillage, monté sur la porte et apte à coopérer avec le châssis, cet organe de verrouillage étant mobile entre des positions respectives de verrouillage et de déverrouillage de la porte par rapport au châssis, en ce que la porte est apte à passer, dans la position de verrouillage dudit organe, de ladite position de fermeture vers une position d'évacuation du gaz hors de l'enceinte, dans laquelle la face intérieure de la porte est distante de la surface d'appui, et en ce qu'il est prévu des moyens de rappel, aptes à ramener la porte de sa position d'évacuation vers sa position de fermeture.

Selon d'autres caractéristiques de l'invention :
- dans sa position de verrouillage, l'organe de verrouillage est solidaire en translation, par rapport à la porte, au moins selon un axe globalement perpendiculaire au plan de la porte ;
- dans cette position de verrouillage, un élément élastique est interposé entre l'organe de verrouillage et le châssis ;
- cet élément élastique est interposé entre une extrémité libre de l'organe de verrouillage et le côté intérieur de la surface d'appui ;
- l'élément élastique est un tampon ressort, notamment réalisé en un matériau élastomère ;
- dans sa position de verrouillage, l'organe de verrouillage est mobile en translation par rapport à la porte, au moins selon un axe globalement perpendiculaire au plan de la porte ;
- il est prévu un premier organe de liaison, monté sur l'organe de verrouillage, ainsi qu'un second organe de liaison, monté sur la porte, qui est apte à coulisser par rapport au premier organe de liaison ;
- le premier organe de liaison est une tige, alors que le second organe de liaison est un fourreau, à l'intérieur duquel la tige est apte à coulisser ;
- il est prévu un ressort, interposé entre des surfaces en regard appartenant respectivement aux premier et second organes de liaison ;
- la face intérieure de la porte est munie d'un joint, apte à venir en butée contre ladite surface d'appui ;
- chaque organe de verrouillage est une crémone, mobile en translation selon un axe parallèle au plan de la porte ;
- l'enceinte comprend en outre une valve d'évacuation des gaz, montée sur une paroi du châssis, ladite valve comprenant un corps creux, un clapet anti-retour, reçu dans le corps creux et disposé dans un orifice de la paroi, ainsi qu'au moins un conduit de collecte du gaz, mis en communication avec le corps creux.

L'invention a également pour objet une valve d'évacuation de gaz, destinée à être utilisée avec l'enceinte conforme à l'invention, comprenant des moyens de fixation sur une paroi du châssis de l'enceinte, et se caractérisant en ce qu'elle comporte un corps creux, un clapet anti-retour, reçu dans le corps creux et apte à être disposé dans un orifice de la paroi, ainsi qu'au moins un conduit de collecte du gaz, mis en communication avec le corps creux.

L'invention a enfin pour objet un procédé d'alimentation en gaz, en particulier en azote, de l'enceinte de stockage telle que définie ci-dessus, comprenant notamment les phases suivantes :
- on alimente cette enceinte en continu, selon au moins un débit de balayage; et
- après chaque ouverture de la porte, suivie d'une fermeture correspondante de cette porte, on alimente l'enceinte selon un débit de purge , nettement supérieur au débit de balayage, le débit de purge étant supérieur à au moins 30 fois le débit de balayage.

Selon d'autres caractéristiques de l'invention :
- on alimente l'enceinte selon le débit de purge, pendant une durée telle que le volume de purge ainsi injecté dans l'enceinte correspond à au moins 3 fois le volume de cette enceinte ;
- on stoppe l'alimentation en gaz, selon le débit de purge, lors d'une ouverture de la porte.

L'invention va être décrite ci-après, en référence aux dessins annexés, donnés uniquement à titre d'exemples non limitatifs, dans lesquels :
- la figure 1 est une vue schématique en perspective, illustrant une enceinte de stockage conforme à l'invention ;
- les figures 2 et 3 sont des vues en coupe longitudinale, illustrant un premier mode de réalisation d'une porte appartenant à l'enceinte de la figure 1, dans deux positions différentes ;
- les figures 4 et 5 sont des vues en coupe longitudinale, illustrant un second mode de réalisation d'une porte appartenant à l'enceinte de la figure 1, dans deux positions différentes ;
- la figure 6 est une vue en coupe longitudinale, illustrant une valve d'évacuation de gaz, appartenant à l'enceinte de la figure 1 ; et
- la figure 7 est un graphe, illustrant les différentes étapes d'un procédé d'alimentation en gaz de l'enceinte de la figure 1.

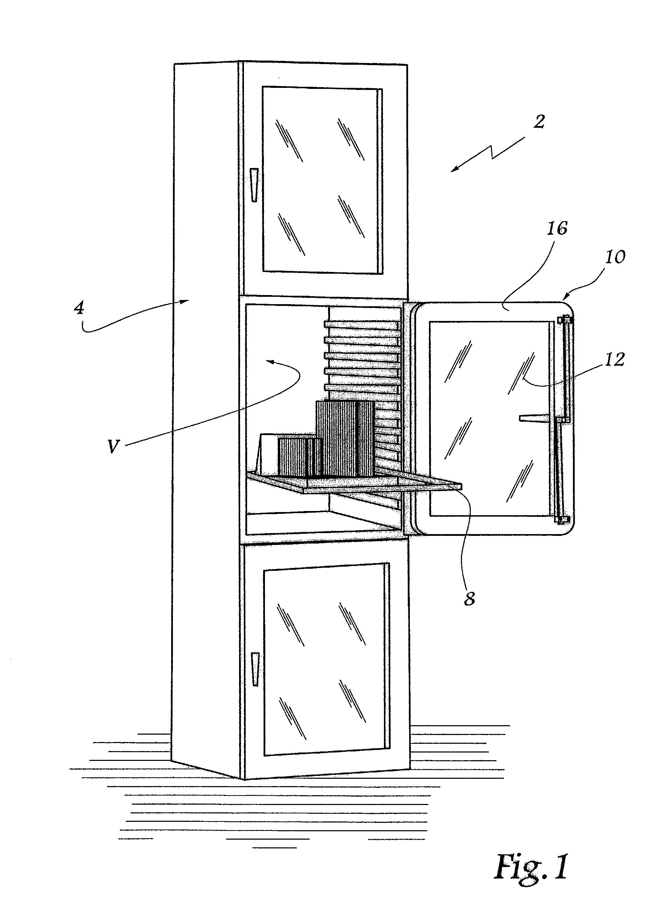

L'enceinte de stockage illustrée à la figure 1, qui est désignée dans son ensemble par la référence 2, comporte un châssis 4 délimitant au moins un compartiment de stockage. Dans l'exemple représenté, ces compartiments sont prévus au nombre de trois, disposés les uns au-dessous des autres.

Le châssis 4 est en outre pourvu de rails de guidage sur lesquels peuvent être placées, de façon amovible, des étagères 8. Ces dernières sont formées par des plateaux perforés, ce qui permet la libre circulation de gaz entre ces étagères.

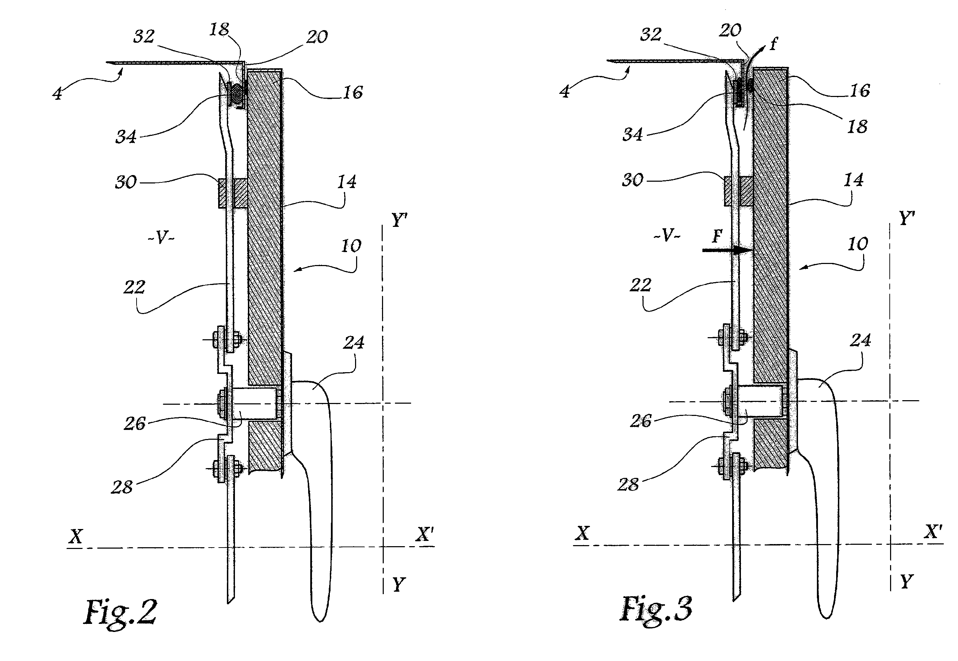

Chaque compartiment de l'enceinte est pourvu d'une porte 10, permettant d'accéder au volume intérieur V de cette enceinte. Comme le montrent également les figures 2 et 3, chaque porte comprend une vitre centrale 12, qui est entourée par une tôle périphérique extérieure 14, elle-même recouverte par un contre-cadre intérieur 16, par exemple réalisé en chlorure de polyvinyle (PVC), ou encore en matériaux conducteurs ou électro-dissipatifs.

Dans la position de fermeture de la porte, illustrée notamment à la figure 2, le contre-cadre 16 prend appui, par l'intermédiaire d'un joint 18, contre une surface en regard du châssis, qui est désignée par la référence 20. Le joint 18 est reçu dans une rainure, non représentée, ménagé dans le contre-cadre 16.

La porte 10 est en outre pourvue de deux organes de verrouillage 22, à savoir des crémones. Celles-ci sont entraînées, de façon classique, par une poignée 24 coopérant avec un axe 26, ainsi qu'une platine 28. Il est à noter que, sur les figures 2 et 3, seule la crémone supérieure est représentée dans son intégralité, alors que la crémone inférieure est illustrée uniquement de façon partielle.

Chaque crémone est mobile axialement selon une direction verticale s'étendant dans le plan de la porte, qui est matérialisée par les repères Y-Y' sur les figures 2 et 3. Sur ces dernières, les crémones sont dans une position de verrouillage, dans laquelle leur extrémité libre s'étend au voisinage de la surface d'appui 20 du châssis.

Dans cet agencement, ces crémones empêchent toute ouverture substantielle de la porte, selon un axe horizontal X-X'.

Chaque crémone possède également une position de déverrouillage, non représentée, dans laquelle son extrémité libre n'est pas disposée en regard de la surface d'appui 20.

Il convient, en outre, de noter que chaque crémone 22 est solidaire en translation de la porte 10, selon l'axe horizontal X-X', qui est globalement perpendiculaire au plan de la porte 10. En effet, la porte est munie d'une oreille 30, dans un orifice de laquelle s'étend la crémone 22, avec possibilité de coulissement vertical.

La figure 2 illustre la position de la porte 10, dans un fonctionnement normal de l'enceinte de stockage. Ceci signifie que la pression du gaz régnant à l'intérieur de cette dernière n'est pas de nature à induire un quelconque danger, notamment d'éclatement dû à une surpression interne.

Dans cette configuration, le joint 18 est écrasé contre le côté extérieur de la surface d'appui 20, ce qui empêche toute évacuation du gaz par la porte, hors du volume intérieur V de l'enceinte. Par ailleurs, l'extrémité libre de la crémone prend appui, avec interposition d'une rondelle 32, contre un tampon ressort 34, formé par exemple d'une matière élastomère. Ce tampon 34 se trouve lui-même placé contre le côté intérieur de la surface 20 du châssis 4.

La figure 3 illustre une autre position de la porte 10, par rapport au châssis 4 de l'enceinte. Dans cet agencement, la force F exercée, sur la porte 10, par la pression du gaz à l'intérieur de l'enceinte, devient supérieure à une valeur prédéterminée correspondant, par exemple, à une pression de 10 mbar.

Dans ces conditions, cette force F repousse l'extrémité libre de la crémone 22 vers la droite, sur la figure 3, ce qui tend à écraser le tampon 34 contre la surface d'appui 20. De la sorte, il se produit un déplacement, vers la droite, de la crémone 22 par rapport au châssis.

Ceci s'accompagne d'un déplacement correspondant de la porte 10 par rapport à ce châssis, et en particulier par rapport à la surface d'appui 20. Par conséquent, ce débattement entre la porte 10 et le châssis 4 amène le joint 18 à s'écarter, vers la droite, par rapport à la surface d'appui 20.

Cet entrebâillement conduit à la création d'un passage d'évacuation de gaz, hors du volume de l'enceinte, qui est matérialisé par la flèche f. Ceci permet de s'affranchir de toute surpression, susceptible d'intervenir dans l'enceinte, et donc de supprimer sensiblement tout risque d'éclatement de cette dernière.

Par ailleurs, les caractéristiques du tampon ressort 34 sont telles, qu'il retrouve sa position initiale lorsque la force exercée par la pression du gaz redevient inférieure à la valeur prédéterminée, évoquée ci-dessus. Ainsi, lorsqu'une quantité suffisante de gaz a été chassée hors de l'enceinte, de façon à rabaisser la pression au-dessous de cette valeur seuil, le tampon 34 ramène par élasticité la crémone 22, et donc la porte 10, dans l'agencement de la figure 2. Ceci permet de retrouver alors une étanchéité satisfaisante.

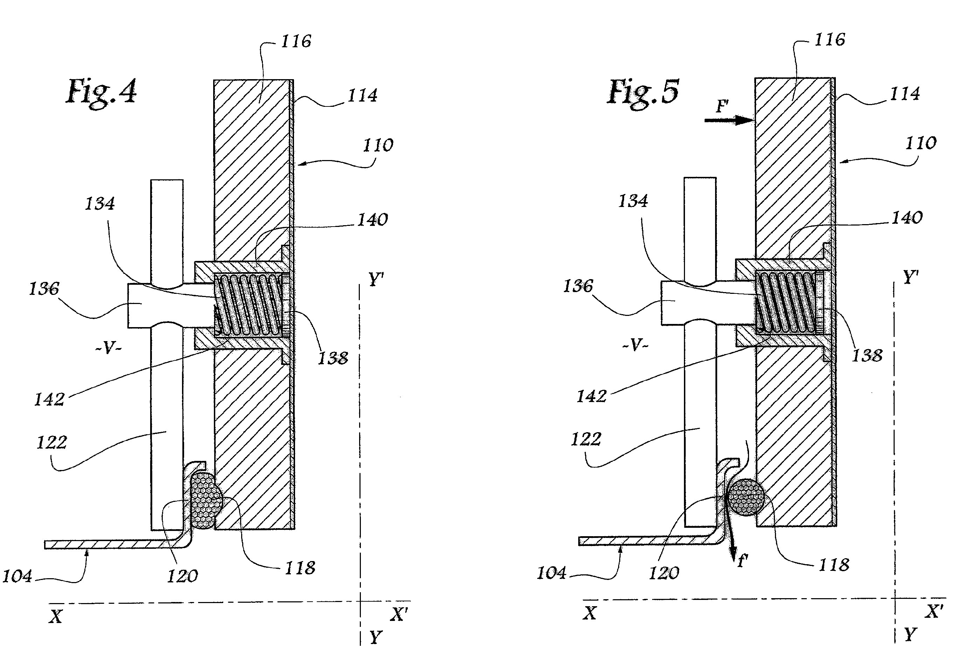

Les figures 4 et 5 illustrent une variante de réalisation de la porte, appartenant à l'enceinte de stockage de la figure 1. Sur ces figures, les organes mécaniques analogues à ceux des figures 2 et 3 sont affectés des mêmes numéros de référence, augmentés de 100.

Sur ces figures 4 et 5, seul le bas de la crémone inférieure est représentée, étant entendu que la partie haute de la crémone supérieure possède une structure similaire. Dans ce mode de réalisation, la crémone 122 est disposée, dans sa position de verrouillage, contre le côté intérieur de la surface d'appui 120, sans interposition du tampon ressort des figures 2 et 3.

Il est par ailleurs prévu une tige horizontale 136, montée sur la crémone 122, à proximité de l'extrémité libre de celle-ci.

De façon plus précise, cette tige 136 est solidaire en translation de la crémone 122, selon l'axe horizontal X-X'. En revanche, la crémone peut coulisser verticalement par rapport à cette tige, et peut également pivoter autour du même axe vertical.

A cet effet, cette crémone possède une section cylindrique, et pénètre dans un orifice correspondant ménagé dans la tige 136. Ceci garantit en outre un montage aisé de ces deux éléments.

La tige 136 est terminée, à l'opposé de la crémone 122, par un épaulement 138, contre laquelle prend appui l'extrémité d'un ressort 134, s'étendant autour de cette tige. En outre, le contre-cadre 116, dont est munie la porte 110, est pourvu d'un fourreau 140, dans lequel coulissent la tige 136 et le ressort 134.

Un rebord intérieur 142, ménagé dans le fourreau, forme une butée pour l'autre extrémité du ressort 134, à l'opposé de l'épaulement 138.

La figure 4 illustre un fonctionnement normal de la porte 110, similaire à celui décrit en référence à la figure 2. Dans cette configuration, l'épaulement 138 est disposé contre la tôle 114 de la porte 110, alors que le joint 118 se trouve écrasé par la porte 110, contre la surface d'appui 120. Ceci contribue à l'étanchéité de l'enceinte.

La figure 5 illustre une autre position de la porte 110, similaire à celle décrite en référence à la figure 3, dans laquelle la force exercée par la pression du gaz, à l'intérieur de l'enceinte, devient supérieure à une valeur prédéterminée.

Cette force, matérialisée par la flèche F', contribue à repousser la porte 110 vers la droite. Or, étant donné que la crémone 122 se trouve immobilisée en appui contre la surface 120, le fourreau 140 coulisse vers la droite, sur la figure 5, par rapport à la tige 136.

Ceci conduit, d'une part, à comprimer le ressort 134 et, d'autre part, à décoller le joint 118 par rapport à la surface d'appui 120. Ainsi, il se forme un passage d'évacuation de gaz hors de l'enceinte, qui est matérialisé par la flèche f'.

Puis, lorsqu'une quantité suffisante de gaz s'est échappé, de façon à rabaisser la pression au-dessous de la valeur prédéterminée évoquée ci-dessus, le ressort de rappel 134 retrouve sa position de la figure 4. Ceci contribue alors à ramener la porte 110 vers la gauche, et donc à écraser le joint 118 contre la surface d'appui 120. Ainsi, l'étanchéité est à nouveau garantie, grâce à la présence de ce joint 118.

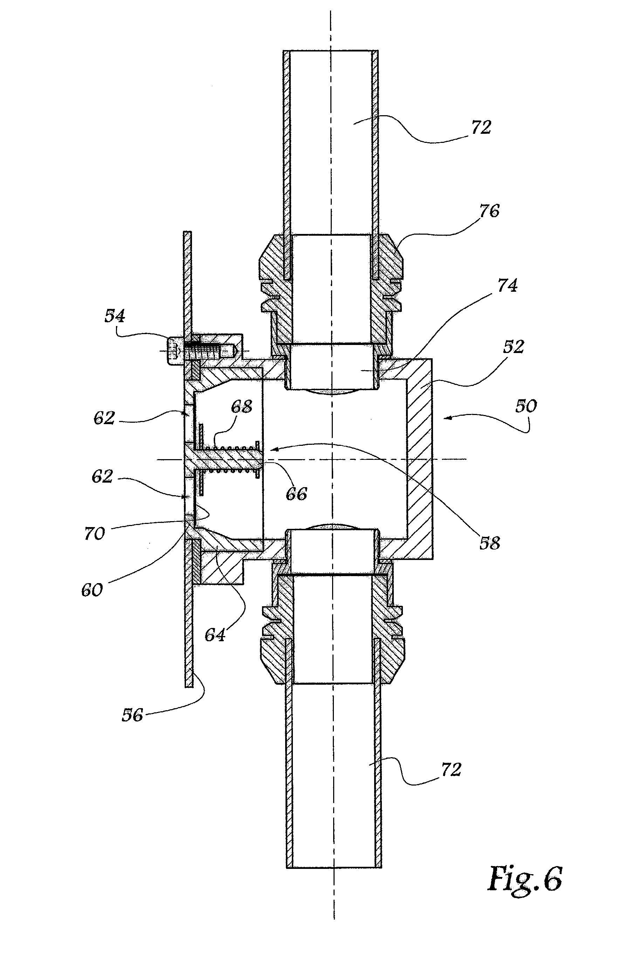

La figure 6 illustre une valve d'évacuation de gaz, dont est équipée l'enceinte de stockage 2.

Cette valve, qui est désignée dans son ensemble par la référence 50, comprend un corps creux 52. Ce dernier se trouve fixé, par des vis 54, sur une paroi 56 appartenant au châssis de l'enceinte de stockage.

Ce corps 52 reçoit, dans son volume intérieur, un clapet anti-retour 58. Celui-ci possède un fond 60, percé d'ouvertures 62, qui est disposé dans un orifice ménagé dans la paroi 56.

Ce fond est prolongé par des parois latérales 64, ainsi que par une tige centrale 66. Cette dernière porte, à son extrémité opposée au fond 60, un ressort 68, solidaire d'une membrane 70, placée au voisinage du fond 60.

Quand la pression à l'intérieur de l'enceinte devient supérieure à une valeur prédéterminée, la membrane 70 se décolle du fond 60, ce qui permet au gaz de s'échapper par les ouvertures 62. Puis, lorsque la valeur de la pression diminue, cette membrane 70 vient à nouveau se plaquer contre les ouvertures 62, de manière à empêcher toute sortie de gaz.

L'intérieur du corps creux 52 est en outre en communication avec deux gaines 72, permettant l'évacuation du gaz. A cet effet, un réducteur 74, fixé dans une paroi du corps, reçoit un raccord 76, qui est lui-même solidaire d'une gaine correspondante 72.

La valve 50, décrite en référence à la figure 6, présente de nombreux avantages spécifiques.

Elle permet en effet de réunir, en mettant en oeuvre un nombre restreint d'éléments constitutifs, de nombreuses fonctions.

Elle assure tout d'abord la traversée de la paroi 56, ainsi que la collecte des gaz évacués, collecte rendue nécessaire par la manipulation de gaz inertes, présentant des risques potentiels d'anoxie pour les opérateurs.

Par ailleurs, elle contribue à maintenir dans l'enceinte, une surpression donnée, par exemple de 1 mbar, lorsqu'un faible débit de gaz est injecté, par exemple inférieur à 1 Nm³/h.

Cette valve assure en outre une limitation de la surpression, à une valeur qui est par exemple de 2 mbar, lorsqu'un débit de purge de 12 Nm³/h est injecté, tout en évitant le retour des gaz évacués.

Il convient de noter que, dans le cas où la valve 50 ne serait plus opérationnelle, par exemple en cas d'obturation accidentelle, une éventuelle surpression à l'intérieur de l'enceinte pourrait être évitée, par ouverture de sa porte, comme explicité en référence aux figures 2 à 5.

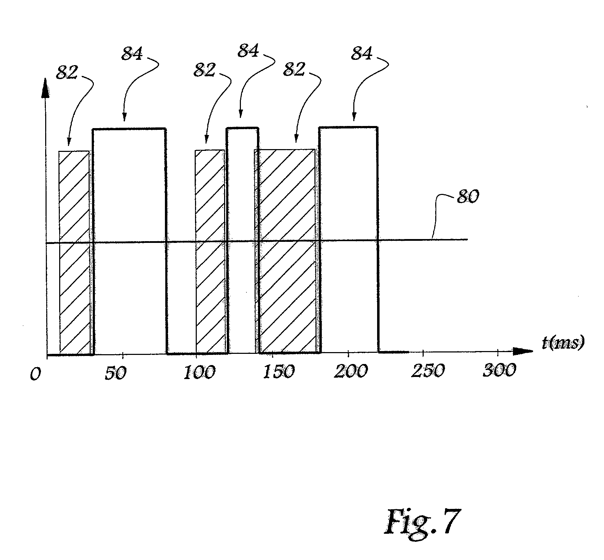

La figure 7 illustre les différentes étapes d'un procédé d'alimentation de l'enceinte 2, au moyen d'un gaz sec, tel que de l'azote. Sur cette courbe, le temps est porté en abscisses, alors que les débits sont portés en ordonnées.

On dirige tout d'abord vers l'enceinte, de façon continue, un débit minimal de gaz, matérialisé par la droite 80. Ce débit de balayage permet de renouveler, en permanence, le gaz présent dans l'enceinte, qui se trouve progressivement contaminé en impuretés. A titre indicatif, ce débit de balayage est voisin de 1 Nm³/h, pour une enceinte dont le volume est de 1 m³.

Sur la figure 7, l'ouverture de la porte est matérialisée par des zones hachurées 82. Après chacune de ces ouvertures, suivies de fermetures correspondantes, il s'agit d'injecter, dans l'enceinte, du gaz selon un débit nettement plus élevé que le débit de balayage évoqué ci-dessus.

Ce débit de purge de l'enceinte se trouve ainsi au moins 30 à 60 fois supérieur au débit de balayage permanent. Ces opérations sont matérialisées par les segments 84.

De façon avantageuse, on réalise cette phase de purge pendant une durée telle, que le volume total de gaz injecté correspond à au moins 3 fois le volume de l'enceinte. Cette mesure permet de rétablir l'atmosphère sèche dans l'enceinte, par exemple en rabaissant le point de rosée au-dessous de -20°C, de façon particulièrement rapide, par exemple en moins de 5 minutes.

Il convient de noter que, pour des raisons de sécurité, la réouverture de la porte, alors qu'une purge est en cours, occasionne l'arrêt immédiat de celle-ci. Cette purge sera de nouveau effectuée, lorsque la porte aura été refermée.

Ainsi, l'opérateur ne peut être exposé à une injection massive de gaz inerte. Les risques potentiels d'anoxie sont donc éliminés.

## Revendications

1. Enceinte de stockage (2), notamment pour des plaquettes de silicium destinées à la micro-électronique, comprenant un châssis (4 ; 104), des moyens de fourniture d'un gaz, notamment de l'azote, ainsi qu'au moins une porte (10 ; 110) permettant d'accéder à un volume intérieur (V) de l'enceinte, la face intérieure (18 ; 118) de la porte prenant appui, dans une position de fermeture (figures 2 et 4), contre une surface d'appui (20 ; 120) appartenant au châssis, l'enceinte comportant également au moins un organe de verrouillage (22 ; 122), monté sur la porte et apte à coopérer avec le châssis, cet organe de verrouillage étant mobile entre des positions respectives de verrouillage et de déverrouillage de la porte (10 ; 110) par rapport au châssis (4 ; 104),
**caractérisée en ce que** la porte est apte à passer, dans la position de verrouillage dudit organe (22 ; 122), de ladite position de fermeture (figures 2 et 4) vers une position d'évacuation (figures 3 et 5) du gaz hors de l'enceinte, dans laquelle la face intérieure (18 ; 118) de la porte est distante de la surface d'appui (20 ; 120), ceci dès que la pression du gaz à l'intérieur de l'enceinte devient supérieure à une valeur prédéterminée, et **en ce qu'**il est prévu des moyens de rappel (34 ; 134), aptes à ramener la porte (10 ; 110) de sa position d'évacuation vers sa position de fermeture, ceci dès que la pression du gaz à l'intérieur de l'enceinte redevient inférieure à ladite valeur prédéterminée.

2. Enceinte selon la revendication 1, **caractérisée en ce que**, dans sa position de verrouillage, l'organe de verrouillage (22) est solidaire en translation, par rapport à la porte (10), au moins selon un axe (X-X') globalement perpendiculaire au plan de la porte.

3. Enceinte selon la revendication 2, **caractérisée en ce que**, dans cette position de verrouillage, un élément élastique (34) est interposé entre l'organe de verrouillage (22) et le châssis (4).

4. Enceinte selon la revendication 3, **caractérisée en ce que** cet élément élastique (34) est interposé entre une extrémité libre de l'organe de verrouillage (22) et le côté intérieur de la surface d'appui (20).

5. Enceinte selon la revendication 3 ou 4, **caractérisée en ce que** l'élément élastique est un tampon ressort (34), notamment réalisé en un matériau élastomère.

6. Enceinte selon la revendication 1, **caractérisée en ce que**, dans sa position de verrouillage, l'organe de verrouillage (122) est mobile en translation par rapport à la porte (110), au moins selon un axe (X-X') globalement perpendiculaire au plan de la porte.

7. Enceinte selon la revendication 6, **caractérisée en ce qu'**il est prévu un premier organe de liaison (136), monté sur l'organe de verrouillage (122), ainsi qu'un second organe de liaison (140), monté sur la porte (110), qui est apte à coulisser par rapport au premier organe de liaison (136).

8. Enceinte selon la revendication 7, **caractérisée en ce que** le premier organe de liaison est une tige (136), alors que le second organe de liaison est un fourreau (140), à l'intérieur duquel la tige est apte à coulisser.

9. Enceinte selon la revendication 7 ou 8, **caractérisée en ce qu'**il est prévu un ressort (134), interposé entre des surfaces en regard (138, 142) appartenant respectivement aux premier et second organes de liaison (136, 140).

10. Enceinte selon l'une quelconque des revendications précédentes, **caractérisée en ce que** la face intérieure de la porte (10 ; 110) est munie d'un joint (18 ; 118), apte à venir en butée contre ladite surface d'appui (20 ; 120).

11. Enceinte selon l'une quelconque des revendications précédentes, **caractérisée en ce que** chaque organe de verrouillage est une crémone (22 ; 122), mobile en translation selon un axe parallèle au plan de la porte (10 ; 110).

12. Enceinte selon l'une quelconque des revendications précédentes, **caractérisée en ce qu'**elle comprend en outre une valve (50) d'évacuation des gaz, montée sur une paroi (56) du châssis, ladite valve comprenant un corps creux (52), un clapet anti-retour (58), reçu dans le corps creux et disposé dans un orifice de la paroi (56), ainsi qu'au moins un conduit (72) de collecte du gaz, mis en communication avec le corps creux.

13. Valve d'évacuation de gaz (50), destinée à être utilisée avec l'enceinte conforme à la revendication 12, comprenant des moyens de fixation (54) sur une paroi (56) du châssis de l'enceinte, **caractérisée en ce qu'**elle comporte un corps creux (52), un clapet anti-retour (58), reçu dans le corps creux et apte à être disposé dans un orifice de la paroi (56), ainsi qu'au moins un conduit (72) de collecte du gaz, mis en communication avec le corps creux.

14. Procédé d'alimentation en gaz, en particulier en azote, de l'enceinte de stockage conforme à l'une quelconque des revendications 1 à 12, comprenant notamment les phases suivantes :
- on alimente cette enceinte (2) en continu, selon au moins un débit de balayage (80) ; et
- après chaque ouverture de la porte (10 ; 110), suivie d'une fermeture correspondante de cette porte, on alimente l'enceinte selon un débit de purge (84), nettement supérieur au débit de balayage,
**caractérisé en ce que** le débit de purge (84) est supérieur à au moins 30 fois le débit de balayage (80).

15. Procédé selon la revendication 14, **caractérisé en ce qu'**on alimente l'enceinte selon le débit de purge, pendant une durée telle que le volume de purge ainsi injecté dans l'enceinte correspond à au moins 3 fois le volume de cette enceinte.

16. Procédé selon l'une quelconque des revendications 14 ou 15, **caractérisé en ce qu'**on stoppe l'alimentation en gaz, selon le débit de purge, lors d'une ouverture de la porte.
